(19) Europäisches Patentamt / European Patent Office / Office européen des brevets

(11) **EP 3 683 989 A1**

(12) **EUROPEAN PATENT APPLICATION**
published in accordance with Art. 153(4) EPC

(43) Date of publication:
**22.07.2020 Bulletin 2020/30**

(51) Int Cl.:
***H04L 1/00*** *(2006.01)*

(21) Application number: **18856447.0**

(22) Date of filing: **13.09.2018**

(86) International application number:
**PCT/CN2018/105489**

(87) International publication number:
**WO 2019/052504 (21.03.2019 Gazette 2019/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.09.2017 CN 201710824271**

(71) Applicant: **Nokia Technologies Oy
02610 Espoo (FI)**

(72) Inventors:
• **ZHU, Kai
Shanghai 201206 (CN)**
• **CHEN, Yu
Shanghai 201206 (CN)**
• **CAI, Liyu
Shanghai 201206 (CN)**

(74) Representative: **DREISS Patentanwälte PartG
mbB
Friedrichstraße 6
70174 Stuttgart (DE)**

(54) **METHOD AND DEVICE FOR INTERLEAVING DATA IN WIRELESS COMMUNICATION SYSTEM, AND COMPUTER READABLE STORAGE MEDIUM**

(57) Embodiments of the present disclosure relate to a method, device and computer readable medium for interleaving data in a wireless communication system. The method described herein comprises determining, based on a first number of bits in a bit sequence to be interleaved, a second number of rows in a triangular interleaver for interleaving the bits. The method also comprises dividing the bit subsequence into the second number of subsequences associated with the rows, a difference between numbers of bits in any two successive subsequences of the subsequences being a predetermined value. The method further comprises writing the second number of subsequences into the triangular interleaver in an order of the rows, the writing comprising, for a given row in the triangular interleaver, determining, based on an index of the given row, a writing order of bits having odd indexes and bits having even indexes in a subsequence associated with the given row.

300

310 — DETERMINE, BASED ON A FIRST NUMBER OF BITS IN A BIT SEQUENCE TO BE INTERLEAVED, A SECOND NUMBER OF ROWS IN A TRIANGULAR INTERLEAVER FOR INTERLEAVING THE BITS

320 — DIVIDE THE BIT SUBSEQUENCE INTO THE SECOND NUMBER OF SUBSEQUENCES ASSOCIATED WITH THE ROWS, A DIFFERENCE BETWEEN NUMBERS OF BITS IN ANY TWO SUCCESSIVE SUBSEQUENCES OF THE SUBSEQUENCES BEING A PREDETERMINED VALUE

330 — WRITE THE SECOND NUMBER OF SUBSEQUENCES INTO THE TRIANGULAR INTERLEAVER IN AN ORDER OF THE ROWS

Fig. 3

**Description**

**CROSS-REFERENCE OF RELEVANT APPLICATIONS**

The present disclosure claims priority of the Chinese patent application No. 201710824271.2 filed on September 13, 2017, and the entire contents of this prior application are hereby incorporated by reference in its entirety.

**FIELD**

Embodiments of the present disclosure generally relate to wireless communication technologies, and more specifically, to a method, device and computer readable storage medium for interleaving data in a wireless communication system.

**BACKGROUND**

Bit errors often occur in strings in a wireless communication channel. Generally, the existing error correction technology can only detect and correct short error strings. In order to solve the problem on strings of bit errors, interleaving technology is often employed. The interleaving technology can rearrange encoded bits prior to transmission such that successive bits in data are transmitted in a non-successive manner. As such, by means of a deinterleaving operation at a receiving device, long error strings can be redistributed into a plurality of short error strings, such that the correction technology can correct them individually.

In formulation of the latest fifth generation (5G) communication standard, it is proposed that a triangular interleaver (which is also referred to as "triangular buffer") is used for an uplink control channel to perform a data interleaving operation. For example, a sequence of encoded bits at an output of rate matching is written to a triangular interleaver row by row. Once the triangular interleaver is filled, the written encoded bits can be read from the triangular interleaver column by column. However, the legacy triangular interleaver often has a constant minimum spreading distance, which is generally defined by the minimum separation at the output of the interleaver between any two symbols that were adjacent to each other at the input of the interleaver. Given the fact that a pair of channel interleaver and deinterleaver attempts to spread or disperse burst errors as far as possible so that the errors can be corrected with the correction technology as many as possible, the triangular interleaver having a consistent minimum spreading distance clearly limits the decoding performance significantly. Moreover, when high order modulations are applied, a plurality of consecutive encoded bits are used to construct an individual symbol. Hence, the triangular interleaver having the constant minimum spreading distance could be incapable of spreading the erroneous bits evenly over a symbol period, resulting in a degradation of the decoding performance.

**SUMMARY**

A brief summary of various embodiments is given below to provide basic understanding on some aspects of various embodiments. It would be appreciated that the Summary is not intended to identify key points of essential elements or describe the scope of various embodiments. The sole objective thereof is to present some concepts in a simplified form as a preface of the more detailed description below.

In a first aspect, there is provided a method of interleaving data in a wireless communication system. The method comprises determining, based on a first number of bits in a bit sequence to be interleaved, a second number of rows in a triangular interleaver for interleaving the bits. The method also comprises dividing the bit subsequence into the second number of subsequences associated with the rows, a difference between numbers of bits in any two successive subsequences of the subsequences being a predetermined value. The method further comprises writing the second number of subsequences into the triangular interleaver in an order of the rows, the writing comprising, for a given row in the triangular interleaver, determining, based on an index of the given row, a writing order of bits having odd indexes and bits having even indexes in a subsequence associated with the given row.

In a second aspect, there is provided a method of interleaving data in a wireless communication system. The method comprises determining, based on a first number of bits in a bit sequence to be interleaved, a second number of rows and the second number of columns in an interleaved array for interleaving the bits. The method also comprises dividing the bit sequence into the second number of subsequences, a difference between numbers of bits in any two successive subsequences of the subsequences being a predetermined value. The method also comprises writing the second number of subsequences concurrently into the interleaved array, comprising: writing a starting bit in a subsequence having an index of zero in the second number of subsequences at a predetermined location in a diagonal of the interleaved array, and for a subsequent subsequence to the subsequence having the index of zero in the second number of subsequences, writing the subsequent subsequence into the interleaved array based on a third number of bits in the subsequent subsequence.

In a third aspect, there is provided a device for interleaving data in a wireless communication system. The device comprises a processor and a memory having instructions stored thereon. The instructions, when executed by the processor, cause the device to perform the method of the first aspect.

In a fourth aspect, there is provided a device for interleaving data in a wireless communication system. The device comprises a processor and a memory having instructions stored thereon. The instructions, when executed by the processor, cause the device to perform the method of the second aspect.

In a fifth aspect, there is provided a computer readable storage medium comprising machine executable instructions. The machine executable instructions, when executed by a device, cause the device to perform the method of the first aspect.

In a sixth aspect, there is provided a computer readable storage medium comprising machine executable instructions. The machine executable instructions, when executed by a device, cause the device to perform the method of the second aspect.

It would be appreciated that the contents described in Summary are not indented to define the key or essential features of the embodiments of the present disclosure, nor is it intended to be used to limit the scope of the present disclosure. Other features of the present disclosure will become apparent through the description below.

## BRIEF DESCRIPTION OF THE DRAWINGS

Through the following disclosed contents and claims, other objectives, advantages and features of the present disclosure will become more apparent. For the purpose of illustration, preferred embodiments are described in a non-limiting way, with reference to the accompanying drawings in which:

Fig. 1A illustrates a diagram of an wireless communication system 100 that can implement the method according to embodiments of the present disclosure;

Fig. 1B illustrates a simplified diagram of processes performed at a transmitting device 120 and a receiving device 130 of the wireless communication system 100;

Fig. 2 exemplarily illustrates a legacy triangular interleaver;

Fig. 3 illustrates a flowchart of a method 300 of interleaving data according to embodiments of the present disclosure;

Fig. 4 exemplarily illustrates a diagram of writing a plurality of subsequences into an interleaved array according to embodiments of the present disclosure;

Fig. 5 illustrates a flowchart of a method 500 of interleaving data according to embodiments of the present disclosure;

Fig. 6 exemplarily illustrates a diagram of writing a plurality of subsequences into an interleaved array according to embodiments of the present disclosure;

Fig. 7 illustrates a diagram of performance comparison between the legacy solution and an embodiment of the present disclosure in terms of the minimum spreading distance;

Fig. 8 illustrates a diagram of performance comparison between the legacy solution and an embodiment of the present disclosure in terms of the average spreading distance; and

Fig. 9 illustrates a diagram of a communication device 900 adapted to implement embodiments of the present disclosure.

Throughout the drawings, the same or similar reference symbols refer to the same or similar elements.

## DETAILED DESCRIPTION OF EMBODIMENTS

For the purpose of illustration, details will be provided in the following description. However, those skilled in the art would appreciate that the present invention can be implemented without these details. Therefore, the present invention is intended to cover the broadest scope consistent with the principles and features described herein, but not confined within the illustrated embodiments.

It would be appreciated that the terms "first," "second," and the like are only used to distinguishing one element from another. As a matter of fact, the first element can also be referred to as the second element, or vice versa. In addition, it is to be understood that "include" and "comprise" are only used to demonstrate the presence of the feature(s), element(s), function(s) or component(s) as described herein, rather than excluding one or more other features, elements, functions or components.

For ease of illustration, some embodiments of the present invention are introduced herein with wireless communications, such as cellular communications, as the background, and terms, for example in Long Term Evolution/Long Term Evolution-Advanced (LTE/LTE-A) formulated by 3GPP or 5G, are used. However, as those skilled in the art would appreciate, embodiments of the present invention are, by no means, limited to wireless communication systems following the wireless communication protocol formulated by 3GPP, but can be applied to any communication system containing similar problems, such as WLAN, a wired communication system, other communication systems to be developed in the future, or the like.

Similarly, the terminal device in the present disclosure may be user equipment (UE) or any terminal having a wired or wireless communication function, including, but not limited to, a mobile telephone, a computer, a personal digital assistant, gaming device, a wearable device, an on-vehicle communication device, a machine-type communication (MTC) device, a device-to-device (D2D) communication device, a sensor and the like. The term "terminal device" can be used interchangeably with UE, mobile station, subscriber station, mobile terminal, user terminal or wireless device. Moreover, the network device may be a network node, such as a node B (Node B or NB), a basic transceiver station (BTS), a base station (BS) or a base station subsystem (BSS), a relay, a remote radio head (RRH), an access node (AN), an access point (AP) or the like.

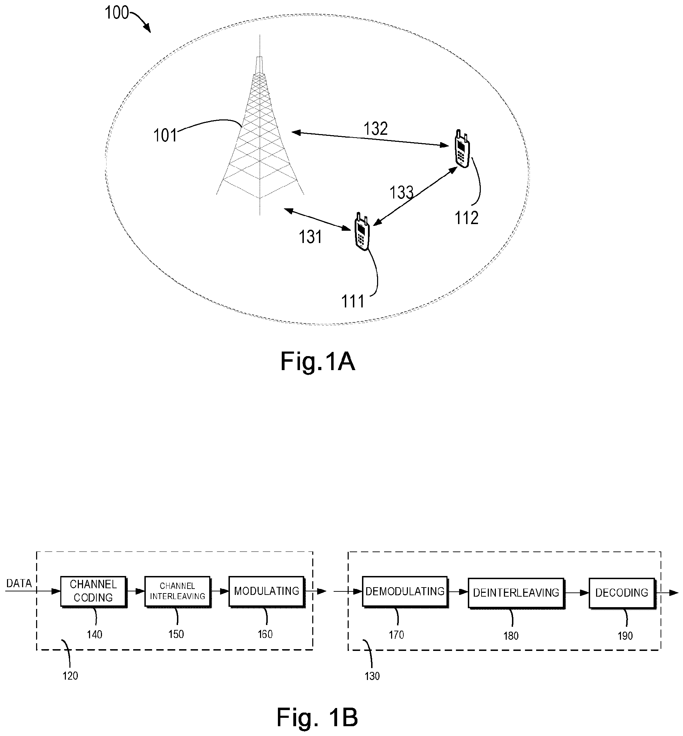

Fig. 1A illustrates a diagram of an example wireless system 100 in which embodiments of the present disclosure can be implemented. The wireless communication system 100 may include one or more network devices 101. For example, in the wireless communication system 100, the network device 101 can be embodied as a base station, such as an evolved node B (eNodeB or eNB). It would be appreciated that the network 101 can be embodied in other forms, for example, a Node B, a basic transceiver station (BTS), a base station (BS) or a base station subsystem (BSS), a relay or the like. The network device 101 provides a wireless connection to a plurality of terminal devices 111 and 112 within its coverage. The terminal devices 111 and 112 can communicate with a network device via a wireless transmission channel 131 or 132 and/or communicate with each other via a transmission channel 133.

Fig. 1B illustrates a simplified diagram of processes performed at a transmitting device 120 and a receiving device 130 of the wireless communication system 100. The network device 101 or terminal devices 111 and 112 in Fig. 1A can act as the transmitting device 120 and/or receiving device 130.

As shown in Fig. 1B, in order to ensure reliable transmission of data (including control signaling), the transmitting device performs channel coding (140) on data to be transmitted to introduce redundancy, so as to counteract distortion probably introduced in the transmission channels (for example, 131, 132 and 133 in Fig. 1A). In addition, the encoded data may undergo channel interleaving (150) so as to rearrange encoded bits prior to transmission to disperse the successive bits in data. Then, the interleaved data can be modulated (160). At the receiving device, a procedure reverse to that of the transmitting device is performed. That is, the received signal is demodulated (170), deinterleaved (180) and decoded (190) to recover the data.

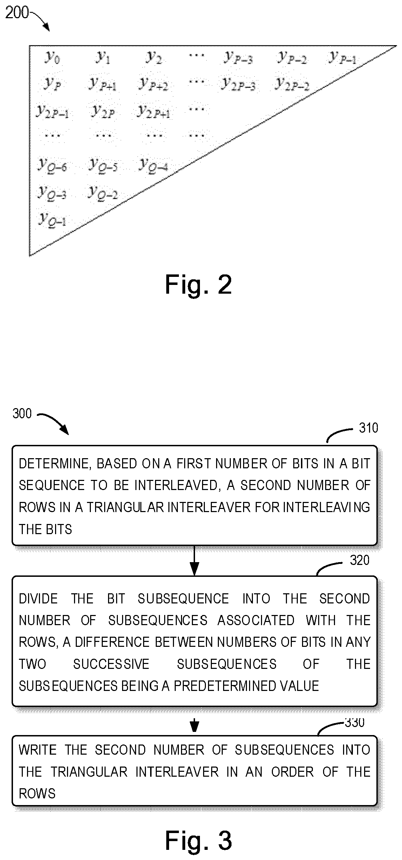

As described above, in the latest 5G communication standard, it is proposed to use a triangular interleaver to implement channel interleaving for an uplink control channel. Fig.2 exemplarily illustrates a schematic diagram of a legacy triangular interleaver.

For example, N encoded bits output at 140 in Fig. 1 can be written to a triangular interleaver 200 as shown in Fig. 2 row by row from top to bottom. The triangular interleaver 200 has a structure of an isosceles right triangle. The isosceles right triangle has a side length P, where P is the smallest integer satisfying $\frac{P(P+1)}{2} \geq N$. As shown in Fig. 2, the triangular interleaver 200 can store at most Q bits. In case of Q>N, Q-N dummy bits are padded after N encoded bits. That is, there are Q bits in total that can be written at locations $y_0$, $y_1$ ... $y_{Q-1}$ in the triangular interleaver 200 row by row from top to bottom. Once the triangular interleaver 200 is filled, the written encoded bits can be read from the triangular interleaver 200, for example, column by column from left to right and from top to bottom, thereby obtaining the interleaved encoded bits.

However, the triangular interleaver 200 has a constant minimum spreading distance, which is generally defined by the minimum separation at the output of the interleaver between any two symbols that were adjacent to each other at the input of the interleaver. For example, as shown in Fig. 2, regardless of the number N of the input encoded bits and the side length P of the isosceles right angle triangle, a bit at the location $y_{P-2}$ and a bit at the closest adjacent location $y_{P-1}$ in the triangular interleaver 200 are separated by one and only one bit, i.e., the bit at the location $y_{2P-2}$ after interleaving. That is, the minimum spreading distance of the triangular interleaver 200 is $d_{min} = 2$.

Given the fact that a pair of channel interleaver and deinterleaver attempts to spread or disperse burst errors as far as possible so that the errors can be corrected with the correction technology as many as possible, the triangular interleaver 200 having the consistent minimum spreading distance (i.e., $d_{min} = 2$) clearly limits the decoding performance significantly. Moreover, when high order modulations are applied, a plurality of consecutive encoded bits are used to construct an individual symbol. Hence, the triangular interleaver 200 having the constant minimum spreading distance of 2 could be incapable of spreading the erroneous bits evenly over a symbol period, resulting in a degradation of the decoding performance. Further, given the fact that an information bit block for a control channel (excluding CRC bits) in 5G has a minimum length of 12 bits, which implies that the transmission block length would be 18 bits in the case of using 3-bit CRC and 5/6 code rate. In this case, the decoding performance will be further degraded.

In order to solve the above problem and one or more of other potential problems, example embodiments of the present disclosure provide a solution for interleaving data in a wireless communication system. In the solution, a triangular interleaver in the legacy solution is still employed, but the manner of writing and reading data for the triangular interleaver is improved. As compared with the legacy solution, the solution can implement a greater minimum spreading distance, especially when a small transmission block length is used. Additionally, the solution supports highly efficient parallel writing and/or reading operation for an interleaver, thereby significantly reducing the system delay.

Now referring to the following drawings, the solution for interleaving data according to embodiments of the present disclosure will be described. For ease of discussion, the description on the following drawings will be provided with reference to the environment as shown in Fig. 1.

Fig. 3 illustrates a flowchart of a method 300 of interleaving data according to embodiments of the present disclosure. The method 300 is implemented at a communication device acting as a transmitting device in the communication network 100. For example, the communication device is one of the terminal devices 111, 112 and the network device 101, as shown in Fig. 1. It would be appreciated that the method may further include additional steps not shown and/or omitting the steps shown therein, and the scope of the present disclosure is not limited in the aspect.

As shown in Fig. 3, at block 310, based on a first number N of bits in a bit sequence to be interleaved, a second number H of rows in a triangular interleaver for interleaving the bit is determined, where N is an integer greater than 1.

In some embodiments, the bits in the bit sequence to be interleaved can be N encoded bits output at 140 in Fig. 1. Particularly, the bits in the bit sequence to be interleaved can also be bits output by a rate-matching unit. For example, the sequence of N bits to be interleaved may be represented as $\{b_0, b_1, b_2,...b_{N-1}\}$.

In some embodiments, the second number H of rows in the triangular interleaver can be a minimum integer which satisfies $\dfrac{H(H+1)}{2} \geq N$. For example, when N = 21, the second number H of rows in the triangular interleaver is 6.

In some embodiments, the triangular interleaver has a structure of an isosceles right triangle, where the isosceles right triangle has a side length of H (the number of rows or columns). Therefore, there are $Q = \dfrac{H(H+1)}{2}$ bits in total which can be accommodated in the triangular interleaver.

In some embodiments, the triangular interleaver forms an upper triangular matrix in an interleaved array, the interleaved array comprising the second number of rows and the second number of columns.

At block 320, the bit sequence is divided into the second number of subsequences associated with the rows, and a difference between numbers of bits in any two successive subsequences of the subsequences is a predetermined value. The predetermined value can be any appropriate value. As an example, the predetermined value may be 1. For example, a sequence having N bits can be divided into a plurality of subsequences, where a subsequence having an index i can include at most i+1 of consecutive bits, and i is a non-negative integer that is less than H. For example, when N = 21 and H = 6, the bit sequence $\{b_0, b_1,...b_{20}\}$ to be interleaved can be divided into 6 subsequences, where the subsequence having the index 0 is $\{b_0\}$, the subsequence having an index of 1 is $\{b_1, b_2\}$, the subsequence having an index of 2 is $\{b_3, b_4, b_5\}$, the subsequence having an index of 3 is $\{b_6, b_7, b_8, b_9\}$, the subsequence having an index of 4 is $\{b_{10}, b_{11}, b_{12}, b_{13}, b_{14}\}$, and the subsequence having an index of 5 is $\{b_{15}, b_{16}, b_{17}, b_{18}, b_{19}, b_{20}\}$.

At block 330, the second number of subsequences is written into the triangular interleaver in an order of the rows. The writing comprises for a given row in the triangular interleaver, determining, based on an index of the given row, a writing order of bits having odd indexes and bits having even indexes in a subsequence associated with the given row. In some embodiments, determining the writing order based on the index of the given row includes determining whether the index of the given row satisfies a predetermined condition. If the index of the given row satisfies the predetermined condition, prior to writing the bits having the even indexes, the bits having the odd indexes in the subsequence associated with the given row are written into the given row. On the other hand, if the index of the given row does not satisfy the predetermined condition, prior to writing the bits having the odd indexes, the bits having the even indexes in the subsequence associated with the given row are written into the given row.

In some embodiments, the predetermined condition may include $\left(\dfrac{i(i+1)}{2}\right) \mod 2 = 1$, where i represents the index of the given row and is a non-negative integer less than the second number.

In embodiments where the bits having odd indexes are written into a given row, the bits are written into the given row in an order in an order from a least significant bit to a most significant bit (i.e., from left to right). In embodiments where the bits having even indexes are written into the given row, the bits are written into the given row in an order from a most significant bit to a least significant bit (i.e., from right to left).

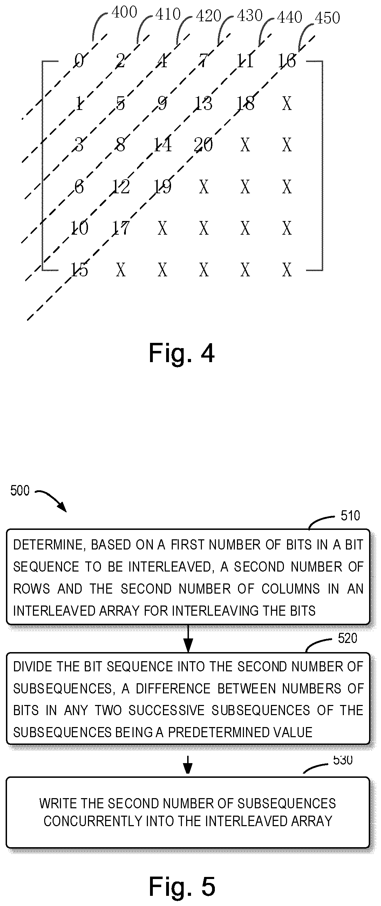

Fig. 4 exemplarily illustrates a diagram of writing a plurality of subsequences into an interleaved array where N = 21 and H = 6. The numbers in Fig. 4 represent serial numbers of the written bits to be interleaved, and "X" indicates an invalid location (NULL). In Fig. 4, the triangular interleaver having the structure of the isosceles right triangle forms an upper triangular matrix in an interleaved array that includes 6 rows and 6 columns. The triangular interleaver includes 6 rows, namely rows 400, 410, 420, 430, 440 and 450. Herein, the row index and the column index are numbered from 0, respectively.

Where N = 21 and H = 6, the bit sequence $\{b_0, b_1, ...b_{20}\}$ to be interleaved may be divided into 6 subsequences, where the subsequence having an index of 0 is $\{b_0\}$, the subsequence having an index of 1 is $\{b_1, b_2\}$, the subsequence having an index of 2 is $\{b_3, b_4, b_5\}$, the subsequence having an index of 3 is $\{b_6, b_7, b_8, b_9\}$, the subsequence having an index of 4 is $\{b_{10}, b_{11}, b_{12}, b_{13}, b_{14}\}$, and the subsequence having an index of 5 is $\{b_{15}, b_{16}, b_{17}, bis, b_{19}, b_{20}\}$. It can be seen from Fig. 4 that a difference between numbers of bits in any two successive subsequences is 1.

The subsequence $\{b_6, b_7, b_8, b_9\}$ having the index of 3 is taken as an example to describe how the subsequence is written into the interleaved array as shown in Fig. 4. For the row 430 having the index of 3 in the triangular interleaver, it is determined whether the index i (i.e., 3) of the row 430 having the index of 3 satisfies $\left(\dfrac{i(i+1)}{2}\right) \mod 2 = 1$. Since the index i of the row 430 having the index of 3 does not satisfy $\left(\dfrac{i(i+1)}{2}\right) \mod 2 = 1$, the bits having even indexes (i.e., $b_6$ and bs) in the subsequence $\{b_6, b_7, b_8, b_9\}$ having the index of 3 associated with the row 430 having the index of 3 are written into the row 430 having the index of 3 prior to writing the bits having the odd indexes (i.e., $b_7$ and $b_8$) (as shown by the arrow).

Specifically, when the bits having odd indexes are written into the row 430 having the index of 3, writing can be performed in an order from left to right, i.e., the bit $b_6$ is first written and then the bit $b_8$ are written. When the bits having even indexes are written into the row 430 having the index of 3, writing can be performed in an order from right to left, i.e., the bit $b_7$ is first written and then the bit $b_9$ are written.

It would be appreciated that the orders of writing the bits having odd indexes and the bits having even indexes into the row 430 having the index of 3 are not mandatory. Alternatively, in some embodiments, bits having odd indexes can be written into the row 430 having the index of 3 prior to writing the bits having odd indexes. However, it would be appreciated that once the order is determined, both the transmitting device and the receiving device should follow the order.

In some embodiments, the method 300 further comprises reading, from an ending row in the interleaved array, the written bits row by row in an order from left to right so as to obtain an interleaved sequence. For example, in the example as shown in Fig. 4, N written bits can be read row by row from left to right and from bottom to top, with invalid bits at invalid locations being skipped, so as to obtain an interleaved sequence {15, 10, 17, 6, 12, 19, 3, 8, 14, 20, 1, 5, 9, 13, 18, 0, 2, 4, 7, 11, 16}.

As seen from the above description, by improving the manner of writing and reading data for a triangular interleaver, the embodiments of the present disclosure can eliminate the restriction of the constant minimum spreading distance of the legacy triangular interleaver. Thus, the system decoding performance is improved. Through parallel performing of write operations and/or at least parallel performing of write and read operations, the embodiments of the present disclosure can improve the system efficiency significantly and reduce the system delay, while reducing the system memory loss.

In some embodiments, the solution for interleaving data according to embodiments of the present disclosure can also be applied to an interleaver having an interleaved array structure. The further description will be provided below in detail with reference to Fig. 5.

Fig. 5 illustrates a flowchart of a method 500 of interleaving data according to embodiments of the present disclosure. The method 500 is implemented at a communication device acting as a transmitting device in a communication network 100. For example, the communication device is one of the terminal devices 111, 112 and the network device 101 in Fig. 1. It would be appreciated that the method 500 can include additional steps not shown and/or omit steps as shown, and the scope of the present disclosure is not limited in this aspect.

As shown in Fig. 5, at block 510, based on a first number N of bits in a bit sequence to be interleaved, a second number H of rows and the second number H of columns in an interleaved array for interleaving the bits are determined, where N is an integer greater than 1.

In some embodiments, the bits in the bit sequence to be interleaved can be N encoded bits output at 140 in Fig. 1. Particularly, the bits in the bit sequence to be interleaved can also be bits output by a rate-matching unit. For example, the sequence of N bits to be interleaved may be represented as $\{b_0, b_1, b_2,...b_{N-1}\}$.

In some embodiments, the second number H of rows and columns in the triangular interleaver can be a minimum integer which satisfies $\frac{H(H+1)}{2} \geq N$. For example, when N = 21, the second number H of rows and columns in the triangular interleaver is 6.

At block 520, the bit sequence is divided into the second number of subsequences, a difference between numbers of bits in any two successive subsequences of the subsequences being a predetermined value. The predetermined value can be any appropriate value. As an example, the predetermined value may be 1. For example, the sequence with N bits can be divided into a plurality of subsequences, where a subsequence having an index i can include at most i+1 of consecutive bits, and i is a non-negative integer less than H. For example, when N = 21 and H = 6, a bit sequence $\{b_0, b_1,...b_{20}\}$ to be interleaved may be divided into 6 subsequences, where the subsequence having an index of 0 is $\{b_0\}$, the subsequence having an index of 1 is $\{b_1, b_2\}$, the subsequence having an index of 2 is $\{b_3, b_4, b_5\}$, the subsequence having an index of 3 is $\{b_6, b_7, b_8, b_9\}$, the subsequence having an index of 4 is $\{b_{10}, b_{11}, b_{12}, b_{13}, b_{14}\}$, and the subsequence having an index of 5 is $\{b_{15}, b_{16}, b_{17}, b_{18}, b_{19}, b_{20}\}$.

At block 530, the second number of subsequences is written concurrently into the triangular interleaver. Specifically, a starting bit in a subsequence having an index of zero in the second number of subsequences is written at a predetermined location in a diagonal of the interleaved array, and for a subsequent subsequence to the subsequence having the index of zero in the second number of subsequences, the subsequent subsequence is written into the interleaved array based on a third number of bits in the subsequent subsequence.

In some embodiments, writing the subsequent subsequence into the interleaved array comprises: iteratively performing the following for at least one time, until the third number is equal to zero: in response to the third number being equal to 1, writing a starting bit in the subsequent subsequence at a subsequent location in the diagonal, an offset of the subsequent location relative to the predetermined location being determined based on an index of the subsequent subsequence; and in response to the third number being greater than 1, writing the starting bit in the subsequent subsequence at a first location in the interleaved array, the first location and the predetermined location having a same column index, writing a bit that is subsequent to the starting bit in the subsequent subsequence at a second location in the interleaved array, the second location and the predetermined location having a same row index, and updating the third number by removing the written bits from the subsequent subsequence.

In some embodiments, a row offset of the first location relative to the predetermined location is determined based on an index of the subsequent subsequence.

In some embodiments, a column offset of the second location relative to the predetermined location is determined based on an index of the subsequent subsequence.

In some embodiments, the predetermined location has a row index of zero and a column index of zero.

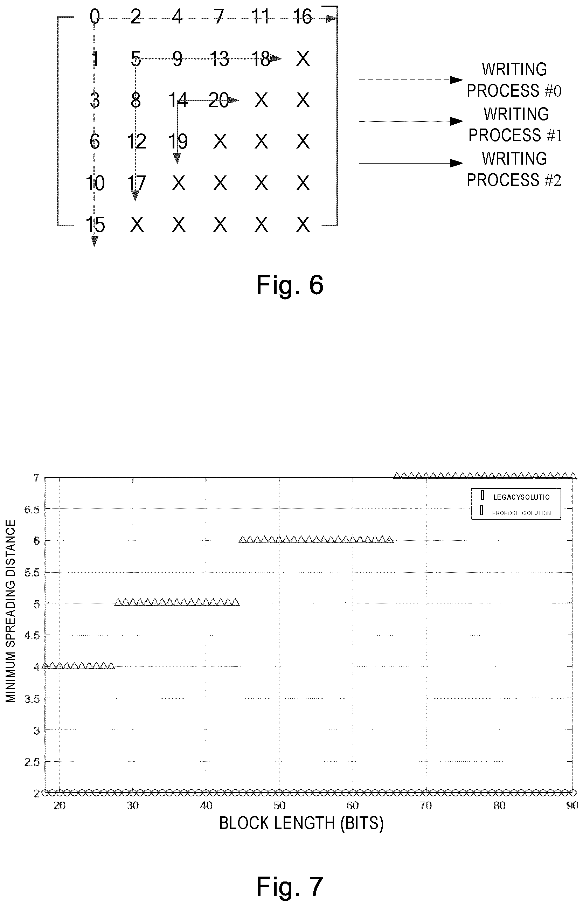

Fig. 6 exemplarily illustrates a diagram of writing a plurality of subsequences into an interleaved array where N = 21 and H = 6. The numbers in Fig. 6 represent serial numbers of written bits to be interleaved, and "X" indicates an invalid location (NULL.

In the example of Fig. 6, where N = 21 and H = 6, the bit sequence $\{b_0, b_1,...b_{20}\}$ to be interleaved may be divided into 6 subsequences, where the subsequence having an index of 0 is $\{b_0\}$, the subsequence having an index of 1 is $\{b_1, b_2\}$, the subsequence having an index of 2 is $\{b_3, b_4, b_5\}$, the subsequence having an index of 3 is $\{b_6, b_7, b_8, b_9\}$, the subsequence having an index of 4 is $\{b_{10}, b_{11}, b_{12}, b_{13}, b_{14}\}$, and the subsequence having an index of 5 is $\{b_{15}, b_{16}, b_{17}, b_{18}, b_{19}, b_{20}\}$. It is seen from Fig. 6 that a difference between numbers of bits in any two successive subsequences is 1.

A starting bit $b_0$ in the subsequence having the index of 0, namely the subsequence $\{b_0\}$ having the index of 0, is written at a predetermined location in the diagonal in the interleaved array. In the example as shown in Fig. 6, the predetermined location has a row index of 0 and a column index of 0. It would be appreciated that this is only provided as an example, the starting bit $b_0$ in the subsequence $\{b_0\}$ having the index of 0 may be written at any location in the diagonal of the interleaved array, and the scope of the present disclosure is not limited in the aspect.

The subsequence $\{b_3, b_4, b_5\}$ having the index of 2 will be taken as an example below to describe how the subsequent subsequence of the subsequence having the index of 2 is written into the interleaved array as shown in Fig. 6.

First, it is determined whether the number of bits in the subsequence having the index of 2 is greater than or equal to 1. Since the number of bits in the subsequence having the index of 2 is 3 at an initial condition, the starting bit $b_3$ in the subsequence having the index of 2 is written at the first location of the interleaved array. The first location and the writing location (i.e., the predetermined location) of the starting bit $b_0$ in the subsequence $\{b_0\}$ having the index of 0 have the same column index. In other words, the starting bit $b_3$ in the subsequence having the index of 2 and the starting bit $b_0$ in the subsequence $\{b_0\}$ having the index of 0 are written into the same column of the interleaved array. In the example where the starting bit $b_0$ in the subsequence $\{b_0\}$ having the index of 0 is written into the column having the index of 0 of the interleaved array, the starting bit $b_3$ in the subsequence having the index of 2 is also written into the column having the index of 0 of the interleaved array. The row offset of the writing location of the starting bit $b_3$ in the subsequence having the index of 2 relative to the writing location of the starting bit $b_0$ in the subsequence $\{bo\}$ having the index of 0 is determined based on the index (i.e., i=2) of the subsequence having the index of 2. For example, the writing location $r_1$ of the bit $b_3$ can be determined such that $r_1=r_0+i$ is satisfied, where ro represents the row index of the writing location of the starting bit $b_0$ in the subsequence $\{b_0\}$ having the index 0, and i represents the index of the subsequence. When $r_0=0$ and i=2, $r_1=2$.

In addition, the bit $b_4$ following the starting bit $b_3$ in the subsequence having the index of 2 is written at a second location of the interleaved array. The second location and the writing location (i.e., the predetermined location) of the starting bit $b_0$ in the subsequence $\{b_0\}$ having the index of 0 have the same row index. In other words, the bit $b_4$ in the subsequence having the index of 2 and the starting bit $b_0$ in the subsequence $\{b_0\}$ having the index of 0 are written into the same row of the interleaved array. In the example where the bit $b_0$ is written into the row having the index of 0 of the interleaved array, the bit $b_4$ is also written into the row having the index of 0 of the interleaved array. The column offset of the writing location of the bit $b_4$ relative to the writing location of the starting bit $b_0$ in the subsequence $\{b_0\}$ having an index of 0 is determined based on the index (i.e., i=2) of the subsequence having the index of 2. For example, the writing location $l_1$ of the bit $b_4$ can be determined such that $l_1=l_0+i$ is satisfied, where $l_0$ represents the column index of the writing location of the starting bit $b_0$ in the subsequence $\{bo\}$ having the index of 0, and i represents the index of the subsequence. When $l_0=0$ and i=2, $l_1=2$.

Next, by removing the written bits $b_3$ and $b_4$ from the subsequence having the index of 2, the number of the bits in the subsequence having the index of 2 is updated to 1.

Thereafter, the following step is iteratively performed: determining whether the number of bits in the subsequence having the index of 2 is greater than 1 or equal to 1. In this case, the number of bits in the subsequence having the index of 2 is equal to 1. Hence, the starting bit $b_5$ in the subsequence having the index of 2 is written at the subsequent location in the diagonal. The offset of the subsequent location relative to the writing location of the starting bit $b_0$ in the subsequence $\{bo\}$ having the index of 0 is determined based on the index of the subsequent subsequence.

For example, the writing location di of the bit $b_5$ in the diagonal can be determined such that $d_1=d_0+i-1$ is satisfied, where do represents the index of the writing location of the starting bit $b_0$ in the subsequence $\{b_0\}$ having the index of 0 in the diagonal, and i represents the index of the subsequence. When $d_0=0$ and i=2, $d_1=1$.

As a consequence, three bits in the subsequence having the index of 2 are all written into the interleaved array. That is, the number of the bits in the subsequence having the index of 2 becomes 0, and the iteration is terminated.

According to embodiments of the present disclosure, for subsequent subsequences of the subsequence $\{b_0\}$ having the index of 0, such as the subsequences having the indexes of 1 to 5, the above iterations is performed concurrently. Thus, the system efficiency is improved and the system delay is reduced significantly while the system memory consumption is reduced.

In some embodiments, the method 500 further includes reading, from an ending row in the interleaved array, the written bits row by row in an order from left to right, so as to obtain the interleaved sequence. For example, in the example as shown in Fig. 6, from the row having the index of 5 in the interleaved sequence, N written bits may be read row by row from left to right and from top to left, with invalid bits at invalid locations being skipped, so as to obtain the interleaved sequence {15, 10, 17, 6, 12, 19, 3, 8, 14, 20, 1, 5, 9, 13, 18, 0, 2, 4, 7, 11, 16}.

The solution for interleaving data in a wireless communication system is described above from the perspective of a transmitting device. However, it would be appreciated that the foregoing operation is reversible. For example, at the receiving device, the reverse operations corresponding to the foregoing interleaving operations can be performed to deinterleave data so as to restore the order of the bits. Meanwhile, it would be appreciated that in some embodiments, the reverse operations corresponding to the foregoing operations can be applied to the transmitting device to perform the interleaving operation, while the foregoing operations can be applied correspondingly at the receiving device to perform a deinterleaving operation, so as to accomplish similar effects. That is, although the solution for interleaving data in a wireless communication system is described above from the perspective of the transmitting device, the solution is not restricted to the application at the transmitting device. Instead, the solution can be applied at a receiving device. For the purpose of simplifying description, all the implementations as described above are not repeated herein. However, it would be appreciated that all of the implementations described above shall fall within the protection scope of the present disclosure.

In addition, although the solution for interleaving data is described above in the environment of a wireless communication system, it would be appreciated that the solution should not be limited to the wireless communication field only. Instead, the solution can also be applied to other fields, such as the field of optical storage or the like, in which scatter storage and/or transmission of successive bits are expected to improve the correction performance.

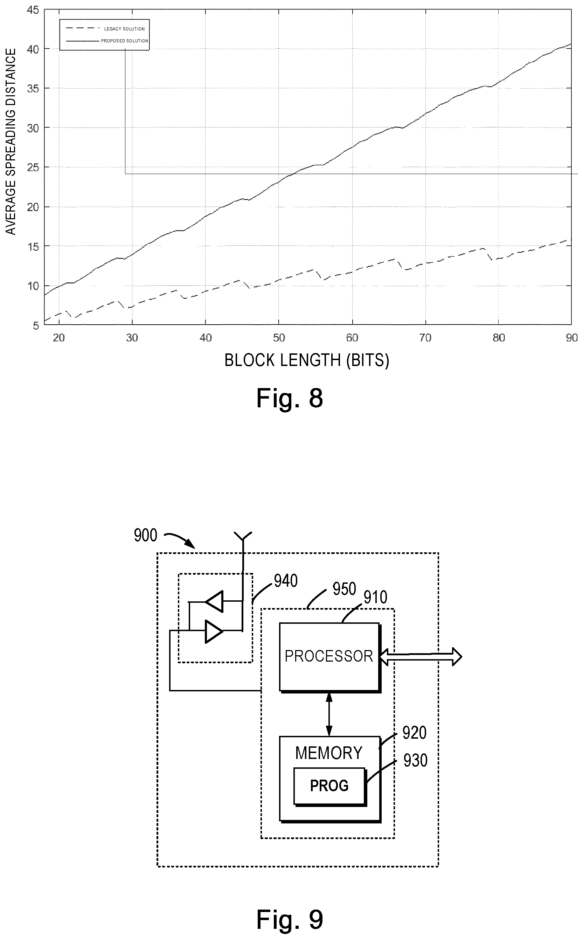

The technical effect of the embodiments of the present disclosure as compared with that of such a legacy solution as shown in Fig. 2 will be described below in detail further with reference to Figs. 7 and 8.

First, the solution for interleaving data according to the embodiments of the present disclosure is compared with the legacy solution as shown in Fig. 2 in terms of the minimum spreading distance and the average spreading distance. For example, the respective equations of the minimum spreading distance and the average spreading distance can be defined below:

$$\text{Minimum spreading distance} = \min_{k=0,1,2\ldots N-1} |\pi(b_k) - \pi(b_{k+1})|$$

$$\text{Average spreading distance} = \frac{\sum\limits_{k=0,1,2\ldots N-1} |\pi(b_k) - \pi(b_{k+1})|}{N-1}$$

Fig. 7 illustrates a diagram of performance comparison between the legacy solution and embodiments of the present disclosure in terms of the minimum spreading distance. As shown in Fig. 7, the curve related to the legacy solution as shown in Fig. 2 is flat because the minimum spreading distance is bounded by 2 regardless of the length of the sequence or the side length of the triangular interleaver. In comparison, for the solution according to the embodiments of the present disclosure, the minimum spreading distance is increased significantly, and thus the system performance can be improved.

Fig. 8 illustrates a diagram of performance comparison between the legacy solution and embodiments of the present disclosure in terms of the average spreading distance. It can be seen again that the technical effect of the solution according to the embodiments of the present disclosure is obviously better than that of the legacy solution as shown in Fig. 2.

Fig. 9 illustrates a diagram of a communication device 900 adapted to implement embodiments of the present disclosure. The device 900 can be used to implement the transmitting device or receiving device in the embodiments of the present disclosure, for example, the network device 101, or the terminal device 111 or 112, as shown in Fig. 1.

As shown in the example in Fig. 9, the communication device can include one or more processors 910, one or more memories 920 coupled to the processor(s) 910, and one or more transmitters and/or receivers (TX/RX) 940 coupled to the processor(s) 910.

The processor 910 can be of any appropriate type adapted to a local technical environment, and can include, but are not limited to, one or more of a general computer, a dedicated computer, a microcontroller, a digital signal controller (DSP), and a processor based on multi-core processor architecture. The communication device 900 can include a plurality of processors, such as dedicated integrated circuit chips temporally slave to a clock in synchronization with a main processor.

The memory 920 can be of any appropriate type adapted to a local technical environment, and can be implemented using any appropriate data storage technique, for example, without limitation, a non-transient computer readable storage medium, a semiconductor-based storage device, a magnetic storage device and system, an optical storage device and system, a fixed memory and a removable memory.

The memory 920 is at least one portion of a storage program 930. TX/RX 940 is provided for bi-directional communication. TX/RX 940 includes at least an antenna for promoting communication, but can have several antennas in practice. A communication interface can represent any interface required by communication with other network elements.

The program 930 can include a program instruction which can cause, when executed by the associated processor 910, the device 900 to be operated according to embodiments of the present disclosure, as described with reference to Figs. 2 and 3. That is, the embodiments of the present disclosure can be implemented by computer software executed by the processor 910 of the communication device 900, hardware or a combination of software and hardware.

Generally, the embodiments of the present disclosure can be implemented in software, hardware, or a combination thereof. Some aspects can be implemented in hardware, while other aspects can be implemented by a controller, microcontroller or firmware or software executed by other computing devices. When each aspect of the embodiments of the present disclosure is illustrated or depicted as a block diagram, flowchart or using some other graphical representations, it would be appreciated that the block, device system, technique or method can be implemented, as a non-limiting example, in hardware, software, firmware, dedicated circuit or logic, general hardware or controller or other computing device, or some combinations thereof. For example, and without limitation, illustrative types of hardware devices that can be used to implement embodiments of the present disclosure include Field-Programmable Gate Arrays (FPGAs), Application-specific Integrated Circuits (ASICs), Application-specific Standard Products (ASSPs), System-on-a-chip systems (SOCs), Complex Programmable Logic Devices (CPLDs), and the like.

As an example, the embodiments of the present disclosure can be described in the context of the machine executable instruction which is included, for example, in a program module executed in a device on a target physical or virtual processor. Generally, the program module includes a routine, program, library, object, class, component, data structure and the like, which executes a particular task or implement a particular abstract data structure. In various embodiments, the functions of the program modules can be merged or split among the program modules described herein. A machine executable instruction for a program module can be executed locally or within a distributed device. In a distributed device, a program module can be located in both of a local and a remote storage medium.

Program code for carrying out methods of the present disclosure may be written in any combination of one or more programming languages. The program code may be provided to a processor of a general purpose computer, special purpose computer, or other programmable data processing apparatus, such that the program codes, when executed by the processor or controller, cause the functions/operations specified in the flowcharts and/or block diagrams to be implemented. The program code may execute entirely on a machine, partly on the machine, as a stand-alone software package, partly on the machine and partly on a remote machine or entirely on the remote machine or server.

In the context of this disclosure, a machine readable medium may be any tangible medium that may contain, or store a program for use by or in connection with an instruction execution system, apparatus or device. The machine readable medium may be a machine readable signal medium or a machine readable storage medium. A machine readable medium may include but not limited to an electronic, magnetic, optical, electromagnetic, infrared, or semiconductor system, apparatus, or device, or any suitable combination of the foregoing. More specific examples of the machine readable storage medium would include an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing.

Further, while operations are depicted in a particular order, this should not be understood as requiring that such operations be performed in the particular order shown or in sequential order, or that all illustrated operations be performed, to achieve desirable results. In certain circumstances, multitasking and parallel processing may be advantageous. Likewise, while several specific implementation details are contained in the above discussions, these should not be construed as limitations on the scope of any invention or claim, but rather as descriptions of features that may be specific to particular embodiments of a particular invention. Certain features that are described in the context of separate implementations may also be implemented in combination in a single implementation. Conversely, various features that are described in the context of a single implementation may also be implemented in multiple implementations separately or in any suitable sub-combination.

Although the subject matter has been described in language specific to structural features and/or methodological acts, it is to be understood that the subject matter specified in the appended claims is not necessarily limited to the specific features or acts described above. Rather, the specific features and acts described above are disclosed as example forms of implementing the claims.

**Claims**

1.  A method of interleaving data in a wireless communication system, comprising:

    determining, based on a first number of bits in a bit sequence to be interleaved, a second number of rows in a triangular interleaver for interleaving the bits;
    dividing the bit subsequence into the second number of subsequences associated with the rows, a difference between numbers of bits in any two successive subsequences of the subsequences being a predetermined value; and
    writing the second number of subsequences into the triangular interleaver in an order of the rows, the writing comprising, for a given row in the triangular interleaver, determining, based on an index of the given row, a writing order of bits having odd indexes and bits having even indexes in a subsequence associated with the given row.

2.  The method of claim 1, wherein determining the writing order based on the index of the given row comprises:

    in response to the index of the given row satisfying a predetermined condition, prior to writing the bits having the even indexes, writing the bits having the odd indexes in the subsequence associated with the given row into the given row; and

in response to the index of the given row failing to satisfy the predetermined condition, prior to writing the bits having the odd indexes, writing the bits having the even indexes in the subsequence associated with the given row into the given row.

3. The method of claim 1, wherein the second number of subsequences each comprise consecutive bits of the plurality of bits.

4. The method of claim 1, wherein the predetermined condition comprises $\left(\dfrac{i(i+1)}{2}\right)\mod 2 = 1$, where $i$ represents the index of the given row and is a non-negative integer less than the second number.

5. The method of claim 1, wherein writing into the triangular interleaver comprises:
writing the bits having the odd indexes into the given row in an order from a least significant bit to a most significant bit.

6. The method of claim 1, wherein writing the bits having the even indexes into the given row comprises:
writing the bits into the given row in an order from a most significant bit to a least significant bit.

7. The method of claim 1, wherein determining the second number based on the first number comprises:
determining the second number H to be a minimum integer which satisfies $\dfrac{H(H+1)}{2} \geq N$, where N represents the first number.

8. The method of claim 1, wherein the predetermined value is 1.

9. The method of claim 1, wherein the triangular interleaver forms an upper triangular matrix in an interleaved array, the interleaved array comprising the second number of rows and the second number of columns.

10. The method of claim 9, further comprising:
reading, from an ending row in the interleaved array, the written bits row by row in an order from a least significant bit to a most significant bit.

11. A method of interleaving data in a wireless communication system, comprising:

determining, based on a first number of bits in a bit sequence to be interleaved, a second number of rows and the second number of columns in an interleaved array for interleaving the bits;
dividing the bit sequence into the second number of subsequences, a difference between numbers of bits in any two successive subsequences of the subsequences being a predetermined value; and
writing the second number of subsequences concurrently into the interleaved array, comprising:

writing a starting bit in a subsequence having an index of zero in the second number of subsequences at a predetermined location in a diagonal of the interleaved array, and
for a subsequent subsequence to the subsequence having the index of zero in the second number of subsequences, writing the subsequent subsequence into the interleaved array based on a third number of bits in the subsequent subsequence.

12. The method of claim 11, wherein writing the subsequent subsequence into the interleaved array comprises:

iteratively performing the following for at least one time, until the third number is equal to zero:

in response to the third number being equal to 1, writing a starting bit in the subsequent subsequence at a subsequent location in the diagonal, an offset of the subsequent location relative to the predetermined location being determined based on an index of the subsequent subsequence; and
in response to the third number being greater than 1,

writing the starting bit in the subsequent subsequence at a first location in the interleaved array, the first location and the predetermined location having a same column index,

writing a bit that is subsequent to the starting bit in the subsequent subsequence at a second location in the interleaved array, the second location and the predetermined location having a same row index, and

updating the third number by removing the written bits from the subsequent subsequence.

13. The method of claim 12, wherein the subsequent location is determined such that the subsequent location satisfies $d_1=d_0+j-1$, where do represents an index of the predetermined location in the diagonal, and j represents an index of the subsequent subsequence.

14. The method of claim 12, wherein a row offset of the first location relative to the predetermined location is determined based on an index of the subsequent subsequence.

15. The method of claim 14, wherein the first location is determined such that the first location satisfies $r_1=r_0+k$, where ro represents a row index of the predetermined location, and k represents an index of the subsequent subsequence.

16. The method of claim 12, wherein a column offset of the second location relative to the predetermined location is determined based on an index of the subsequent subsequence.

17. The method of claim 16, wherein the second location is determined such that the second location satisfies $l_1=l_0+m$, where $l_0$ represents a column index of the predetermined location, and m represents an index of the subsequent subsequence.

18. The method of claim 11, wherein the second number of subsequences each comprise consecutive bits of the plurality of bits.

19. The method of claim 11, wherein determining the second number based on the first number comprises:

determining the second number H to be a minimum integer which satisfies $\dfrac{H(H+1)}{2} \geq N,$

where N represents the first number.

20. The method of claim 11, wherein the predetermined location has a row index of zero and a column index of zero.

21. The method of claim 11, wherein the predetermined value is 1.

22. The method of claim 11, further comprising:
reading, from an ending row in the interleaved array, the written bits row by row in an order from a least significant bit to a most significant bit.

23. A device for interleaving data in a wireless communication system, comprising:

a processor; and
a memory having instructions stored thereon, the instructions, when executed by the processor, causing the device to perform the method of any of claims 1-10.

24. A device for interleaving data in a wireless communication system, comprising:

a processor; and
a memory having instructions stored thereon, the instructions, when executed by the processor, causing the device to perform the method of any of claims 11-22.

25. A computer readable storage medium comprising machine executable instructions, the machine executable instructions, when executed by a device, causing the device to perform the method of any one of claims 1-10.

26. A computer readable storage medium comprising machine executable instructions, the machine executable instructions, when executed by a device, causing the device to perform the method of any one of claims 11-22.

Fig.1A

Fig. 1B

Fig. 2

DETERMINE, BASED ON A FIRST NUMBER OF BITS IN A BIT SEQUENCE TO BE INTERLEAVED, A SECOND NUMBER OF ROWS IN A TRIANGULAR INTERLEAVER FOR INTERLEAVING THE BITS

DIVIDE THE BIT SUBSEQUENCE INTO THE SECOND NUMBER OF SUBSEQUENCES ASSOCIATED WITH THE ROWS, A DIFFERENCE BETWEEN NUMBERS OF BITS IN ANY TWO SUCCESSIVE SUBSEQUENCES OF THE SUBSEQUENCES BEING A PREDETERMINED VALUE

WRITE THE SECOND NUMBER OF SUBSEQUENCES INTO THE TRIANGULAR INTERLEAVER IN AN ORDER OF THE ROWS

Fig. 3

400 410 420 430 440 450

$$
\begin{bmatrix}
0 & 2 & 4 & 7 & 11 & 16 \\
1 & 5 & 9 & 13 & 18 & X \\
3 & 8 & 14 & 20 & X & X \\
6 & 12 & 19 & X & X & X \\
10 & 17 & X & X & X & X \\
15 & X & X & X & X & X
\end{bmatrix}
$$

## Fig. 4

500

DETERMINE, BASED ON A FIRST NUMBER OF BITS IN A BIT SEQUENCE TO BE INTERLEAVED, A SECOND NUMBER OF ROWS AND THE SECOND NUMBER OF COLUMNS IN AN INTERLEAVED ARRAY FOR INTERLEAVING THE BITS

510

DIVIDE THE BIT SEQUENCE INTO THE SECOND NUMBER OF SUBSEQUENCES, A DIFFERENCE BETWEEN NUMBERS OF BITS IN ANY TWO SUCCESSIVE SUBSEQUENCES OF THE SUBSEQUENCES BEING A PREDETERMINED VALUE

520

WRITE THE SECOND NUMBER OF SUBSEQUENCES CONCURRENTLY INTO THE INTERLEAVED ARRAY

530

## Fig. 5

Fig. 6

Fig. 7

Fig. 8

Fig. 9

# EP 3 683 989 A1

## INTERNATIONAL SEARCH REPORT

| International application No. |
|---|
| **PCT/CN2018/105489** |

### A. CLASSIFICATION OF SUBJECT MATTER

H04L 1/00(2006.01)i

According to International Patent Classification (IPC) or to both national classification and IPC

### B. FIELDS SEARCHED

Minimum documentation searched (classification system followed by classification symbols)

H04W HO4L H04B

Documentation searched other than minimum documentation to the extent that such documents are included in the fields searched

Electronic data base consulted during the international search (name of data base and, where practicable, search terms used)

CNPAT, CNKI, WPI, EPODOC, 3GPP: TRIANGULAR INTERLEAVE BUFFER BIT SEQUENCE POLAR CODE NUMBER ODD EVEN INDEX ROW LINE READ WRITE 三角 三角形 交织 缓冲器 比特 序列 极化码 数目 奇 偶 索引 行 列 读 写

### C. DOCUMENTS CONSIDERED TO BE RELEVANT

| Category* | Citation of document, with indication, where appropriate, of the relevant passages | Relevant to claim No. |
|---|---|---|
| A | NOKIA et al. "Bit-Interleaving for Polar Codes" <br> *3GPP TSG RAN WG1 Meeting NR#3, R1-1716561*, 12 September 2017 (2017-09-12), <br> sections 2.1.1, 2.1.2 and 2.1.4 | 1-26 |
| A | QUALCOMM INCORPORATED. "Design and Evaluation of Interleaver for Polar Codes" <br> *3GPP TSG-RAN RAN1#90, R1-1713474*, 25 August 2017 (2017-08-25), <br> entire document | 1-26 |
| A | CN 106817195 A (HUAWEI TECHNOLOGIES CO., LTD.) 09 June 2017 (2017-06-09) <br> entire document | 1-26 |
| A | CN 106230489 A (XIDIAN UNIVERSITY) 14 December 2016 (2016-12-14) <br> entire document | 1-26 |
| A | CN 101874351 A (SONY CORPORATION) 27 October 2010 (2010-10-27) <br> entire document | 1-26 |
| A | US 2016234054 A1 (KANTER, J.) 11 August 2016 (2016-08-11) <br> entire document | 1-26 |

☐ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **15 November 2018** | **28 November 2018** |

| Name and mailing address of the ISA/CN | Authorized officer |
|---|---|
| **State Intellectual Property Office of the P. R. China** <br> **No. 6, Xitucheng Road, Jimenqiao Haidian District, Beijing 100088** <br> **China** | |
| Facsimile No. **(86-10)62019451** | Telephone No. |

Form PCT/ISA/210 (second sheet) (January 2015)

# EP 3 683 989 A1

**INTERNATIONAL SEARCH REPORT**
Information on patent family members

International application No.

**PCT/CN2018/105489**

| Patent document cited in search report | | | Publication date (day/month/year) | Patent family member(s) | | | Publication date (day/month/year) |
|---|---|---|---|---|---|---|---|
| CN | 106817195 | A | 09 June 2017 | WO | 2017092543 | A1 | 08 June 2017 |
| CN | 106230489 | A | 14 December 2016 | None | | | |
| CN | 101874351 | A | 27 October 2010 | ZA | 201003441 | B | 25 May 2011 |
| | | | | KR | 20100096096 | A | 01 September 2010 |
| | | | | EP | 2237430 | A2 | 06 October 2010 |
| | | | | TW | 200937871 | A | 01 September 2009 |
| | | | | WO | 2009069629 | A1 | 04 June 2009 |
| | | | | EA | 201070628 | A1 | 28 February 2011 |
| | | | | EP | 2950452 | A2 | 02 December 2015 |
| | | | | NZ | 585419 | A | 26 April 2013 |
| | | | | MY | 159732 | A | 31 January 2017 |
| | | | | EP | 2216907 | A1 | 11 August 2010 |
| | | | | AU | 2008330672 | A2 | 08 July 2010 |
| | | | | JP | WO2009069629 | A1 | 14 April 2011 |
| | | | | BR | PI0820168 | A2 | 16 June 2015 |
| | | | | AU | 2008330672 | A1 | 04 June 2009 |
| | | | | US | 2010269019 | A1 | 21 October 2010 |
| US | 2016234054 | A1 | 11 August 2016 | None | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201710824271